# EUROPEAN PATENT SPECIFICATION

(11) **EP 4 035 269 B1**
(45) Date of publication and mention of the grant of the patent: **06.05.2026**
(21) Application number: 20781643.0
(22) Date of filing: 25.09.2020
(51) Int. Cl.: H03K 17/22

(54) **POR CIRCUIT**
POR-SCHALTUNG
CIRCUIT POR

(30) Priority: 25.09.2019 NL 2023897
(43) Date of publication of application: 03.08.2022
(73) Proprietor: Nexperia B.V., 6534 AB Nijmegen (NL)
(72) Inventor: XU, Weichen, 2629 JD DELFT (NL); MARTINS, Gustavo Campos, 2629 JD DELFT (NL)
(74) Representative: Pjanovic, Ilija
(86) International application number: PCT/NL2020/050599
(87) International publication number: WO 2021/060986

(56) References cited:
- US-B1- 6 650 155
- US-B1- 9 882 558

## Description

### Technical field

The present invention relates, in general, to a Power-On Reset, POR, circuit for generating a control signal to power-on a load, such as a wireless sensor node, for resetting at least one register of said load, with improved efficiency and cold-start capability.

### Background

A Power-On-Reset, POR, circuit is an electronic circuit that detects if power is applied to a given electrical device and generates a control signal to the entire device circuit placing it into a known state. The purpose of a POR circuit is to delay start of operation of the device after power is applied until the supply voltage reaches a predetermined nominal value and stabilizes at the correct levels. This ensures that clocks of the processors settle accurately and loading of internal registers is complete before the device actually starts working or gets switched on.

Internet-of-Things, loT, devices or Wireless Sensor Nodes, WSNs, used in various monitoring and sensing applications typically rely on energy harvesting sources. These Plug & Forget devices minimize the need for human intervention, ensure continuous operation for years or even decades and are very environment friendly. The device can further be equipped with an additional power source like a battery or capacitor, which is charged with the energy harvester. The main drawback of harvesting energy from ambient sources is that the energy present in available energy sources, like temperature difference, light or Radio Frequency signals, is very low. Typically, these available power levels fall below circuit threshold values which are necessary to start up initially. Current solutions for achieving a low power start up require the use of bulky peripheral circuits like off-chip transformers, logic gates and latches, leading to undesired area overhead and large footprint.

POR circuits are known and available with a variety of requirements, which may be optimized for particular purposes. A known example can be seen in US 6 650 155 B1. In known POR circuits there always is a trade-off between optimizations like efficiency or cold-start capability. In loT and WSN applications it is however preferable that both requirements are met. To ensure device operation even with weak sources of ambient energy, it is necessary that POR circuits applied in energy harvesting systems consume ultra-low power..

Furthermore, because of the weak sources of ambient power, the cold start problem is a challenging problem for energy harvesting devices equipped with a POR circuit. At the moment the POR control signal prompts the main function of the device that enough power is available, the device starts working in normal operation mode. This results in a power consumption peak causing a drop of the supply voltage below threshold level of the POR circuit, that in turn a new POR signal is generated instructing the device to stop normal operation mode because not enough power is available. The device will keep toggling between on and off for a long time or even never start operating properly.

In view of the above, there is a need for a POR circuit with improved efficiency and cold-start capability.

### Summary

It is an object of the present invention to provide a Power-On Reset, POR, circuit for generating a control signal to power-on a load, such as a wireless sensor node, for resetting at least one register of said load, with improved efficiency and cold-start capability.

In a first aspect of the invention, this object is provided by a Power-On Reset, POR, circuit as claimed in claim 1.

Internet-of-Things, IoT, and Wireless Sensor Nodes, WSN, devices with energy harvesters may be configured to have different operating modes. In, for example, a first operating mode, the circuit or device may be starting-up and in a second operating mode, the circuit or device may be (fully) operational. The device is typically equipped with a POR circuit arranged for generating a control signal to the device to ensure the device is in a known state before the device actually starts working. After power is applied the start of the second operation mode is delayed until the supply voltage reaches a predetermined nominal value and stabilizes at the correct level.

These IoT or WSN devices that are powered (primarily) from an energy harvesting source are dependent on the low input power of the energy harvester. Without the energy harvesters, the device typically depend to heavily on its primary power supply, i.e. the battery, such that battery replacement is required over a certain time period. The use of the energy harvester may thus significantly postpone or even completely remove the need for replacement of the battery.

In order for the energy harvester to be effective, the POR circuit must be capable of cold-start. This means that the energy harvester may, during his first start-up phase, have a battery which fails to provide a sufficient supply voltage for the device to operate, e.g. due to a fully depleted battery or upon a first start-up of the device after fabrication thereof. Accordingly, a POR circuit is needed in this phase which is able to start-up the device under these challenging conditions.

This cold start problem is resolved by the switching means arranged for selecting a first or a second reference voltage. These two different reference voltages are derived from the voltage reference generator. The voltage comparator compares the first reference voltage or the second reference voltage with the threshold voltage generated by the voltage divider.

When the switching means are in a first position, the threshold voltage is compared with the first reference voltage. Additionally, when the switching means are in second position, the threshold voltage is compared with the second reference voltage. This enables the POR circuit to switch from its first to its second output voltage, e.g. from a high to a low state, when the supply voltage of the circuit exceeds a first predetermined value and to switch from its second to its first output voltage, e.g. from a low to a high state, when the supply voltage eventually drops below a second predetermined value, which is not equal to the first predetermined value. The first and second predetermined values are chosen sufficiently high in dependence of the speed of increase and decrease of the supply voltage.

Due to the fact that the values of the first reference voltage and the second reference voltage are not equal to each other both in value and in time and there is a significant difference between both values, a sufficient large time window is created and flipping or toggling of the output of the POR circuit between two states is prevented.

Because the voltage levels generated by cold-start energy harvesting systems are very low and of large variance, , it is of considerable importance for a robust and efficient POR circuit in cold-start energy harvesting systems that flipping between on and off is prevented. Since the output signal of the POR circuit is responsible for starting the main function of the device, there is a power consumption peak at the moment the POR signal is generated due to the load being active or getting switched on. In turn this power peak lowers the supply voltage of for example the battery or supply voltage capacitor, causing the supply voltage to drop below the threshold of the POR circuit. Because there is not a single threshold value in the POR circuit of the current invention and because the first reference voltage is different and smaller than the second threshold value, a time window is created between turning the device on and off, preventing that the device will keep toggling between on and off for a long time or even never start properly.

It was the insight of the inventor to design a POR circuit consisting of a voltage reference generator, a voltage divider and a voltage comparator using sub-threshold current to operate. Because the whole POR circuit operates at sub-threshold current, the POR circuit consumes ultra-low power with sub-threshold supply currents in the order of less than a nA, preferably with current consumption in the order of hundreds pico-ampere, pA.

A sub-threshold current flows from source to drain in a MOSFET in the cut-off region when the transistor is nominally turned off. In this region, the transistor is operating around the threshold voltage, i.e. below threshold voltage. Working at this region is useful for systems that should work at low voltages, i.e. around 1V. The main benefit working at this region is that the output current is related exponentially with the input voltage rather than the quadratic relationship to the input voltage in saturation region.

The drawback of transistors operating with sub-threshold currents is that these are relatively big, which is very unfavourable in the circuit design of POR circuits.

I first disadvantage is the large footprint. However, because of the inventive design of the POR circuit of the current invention, no peripheral circuit like logic gates and latches and no (off-chip) transformers are needed that would make the area overhead even larger.

Another disadvantage of big transistors is that these transistors create large parasitic capacitors. However, because of the design of the current application, the influence of large parasitic capacitors is minimized because of the slow rising and falling of the supply voltage generated by the energy harvesting source.

Because of the large parasitic capacitor of transistors operating with sub-threshold currents, the respond time is very slow, up to several milliseconds. However, according to the current invention, the threshold voltage of the voltage divider is compared with two different reference voltages generated by the voltage reference generator, causing a time window between outputting the control signals for switching on and off the device. Because of this time window, it is not an issue that the response time of the POR circuit is relatively long. Furthermore, use of transistors operating with sub-threshold currents results in a large resistance at the intermediate node of the voltage divider. Therefore, the input of the voltage comparator connected to this intermediate point is very sensitive to noise. Because of the two different values of the reference voltages to which the threshold voltage is compared, this disadvantage is overcome in the POR circuit of the current invention. In an example, the first output voltage of the POR circuit is a low voltage, for example 0 volts, and the second output voltage is a high voltage, for example equal to said supply voltage.

In another example, the first output voltage of the POR circuit is a low voltage, for example 0 volts, and said second output voltage is equal to the maximum supply voltage.

In yet another example, the first output voltage of the POR circuit is a high voltage, for example equal to said supply voltage., and the second output voltage is a low voltage, for example o volts.

The output voltage of the POR circuit is a control signal which informs the remaining of the circuit, for example an loT device or an WSN, when enough supply power is available ensuring the registers of the circuit are into a known state. The high voltage represents a binary one and the low voltage represents a binary zero.

In an example, the switching means comprise of at least one switch. In another example, the switching means comprise of two switches.

In yet another example, the switching means comprise at least one NMOS and/or PMOS transistor.

Using a switch or transistors for switching between the two predetermined values has the advantage that no peripheral circuit, like logic gates or latches, is required.

In an example, the first reference voltage and the second reference voltage is determined by selecting transistors having corresponding W/L characteristics.

As described before the first and the second predetermined voltage is derived from the voltage reference generator. The exact values for these two predetermined voltages can easily be adapted by using transistors with specific W/L ratios in the design of the voltage reference generator of the POR circuit. When the first and second predetermined voltage need different values, other transistors with deviant W\L characteristics can be used in the voltage reference generator circuit design.

In an example, the POR circuit is further comprising at least one gain stage arranged for amplifying said output voltage of said voltage comparator.

Typically, the voltage levels generated by cold-start energy harvesting systems are very low. To ensure the output voltage the POR circuit is sufficient for the device or circuit in need of receiving the control signal, the POR signal is amplified to the desired value by one or more gain stages.

In an example, the at least one gain stage comprises NMOS and/or PMOS transistors.

In another example, the POR circuit comprises NMOS and/or PMOS transistors.

For the transistors any type of transistor can be used. However, preferably NMOS and/or PMOS are used, because of their advantageous characteristics, like providing greater efficiency while operating at low voltages, fast switching speed and operating at low power.

In an example, the voltage divider is a linear voltage divider.

The voltage reference generator generates a reference voltage, wherein the reference voltage is nonlinear dependent of the supply voltage. The voltage divider generates a threshold voltage, wherein the threshold voltage is linear dependent of the supply voltage. By selecting the MOSFET transistors with specific W/L characteristics for the nonlinear voltage reference generator and the linear voltage divider, the crossing point of the reference voltage with the threshold voltage can easily and accurately be set.

MOSFETs operate at low voltage in cut-off region resulting in ultra-low power consumption with sub-threshold currents in the order of less than a nA.

In an example, the voltage reference generator comprises of a single stage of transistors connected in series, or may comprise a first stage or branches of transistors connected in series in parallel to a second stage or branch branches of transistors connected in series wherein both stages or branches are connected through the gates of one of the transistors.

The voltage reference signal generated by the single stage of MOSFETs is has a large variance and is less precise than when the reference voltage was generated by multiple stages, which typically consist of up to seven intermediate stages. The output voltage of the single stage reference generator can have a variance up to 500 mV, which is undesired for POR circuits already known. However because of the inventive design of the POR circuit of the current invention this is not a problem. However, the main advantage of a single stage voltage reference generator is reduction of current consumption. Current consumption of the single stage voltage generator is between 200 and 400 pA, as the current consumption of multiple stages generators is typically in the order of several nA. Additional advantages of a single stage voltage reference generator is less complex design and less area overhead.

Connecting he MOSFET, operating in cut-off region, in series with the diode connected MOSFETs results in the desired nonlinear behaviour of the voltage reference generator.

The above-mentioned and other features and advantages of the disclosure will be best understood from the following description referring to the attached drawings. In the drawings. Like reference numerals denote identical parts or parts performing an identical or comparable function of operation.

### Brief description of the drawings

Figure 1 illustrates a schematic overview of the POR circuit according to the invention.
Figure 2 illustrates the schematic of an embodiment of the POR circuit according to the invention.
Figure 3 illustrates the first and second crossing point of the reference voltage signal with the threshold voltage signal according to the invention and the input and output voltage signal of the POR circuit according to the invention.
Figure 4 illustrates the schematic of an alternative embodiment of the POR circuit according to the invention.

### Detailed description

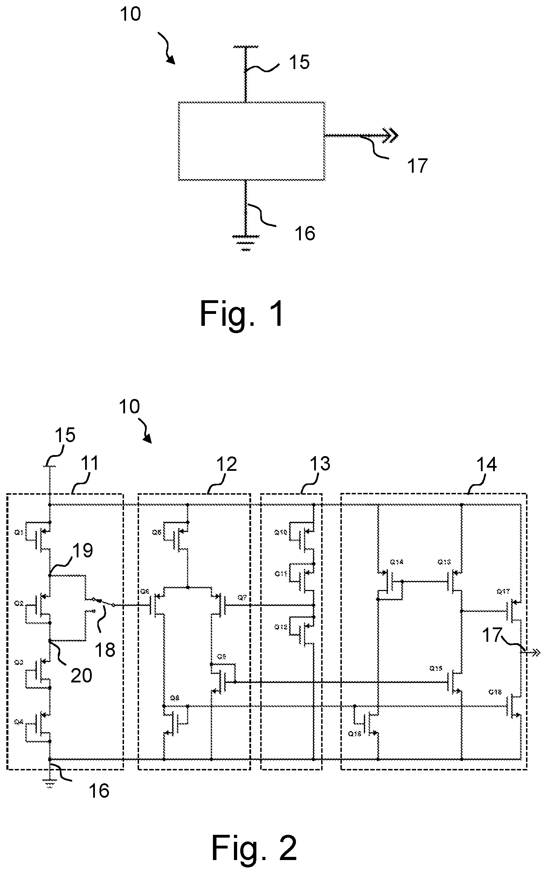

Figure 1 illustrates a schematic overview of the POR circuit according to the invention.

The POR circuit 10 has 3 pins. The supply voltage Vdd, i.e. 3.3 Volts, is applied to pin 15, pin 16 is connected to ground and the output signal of the POR circuit or the control signal is applied to pin 17. To output pin 17 the circuit or load, for example a device or a node, is connected. When the POR circuit detects that the supply voltage is stabilized and at the correct level, the circuit or load gets the control signal for starting normal operation mode. This ensures that clocks of the processors settle accurately and loading of internal registers is completed.

When the threshold value, which is a linear fraction of the supply voltage, rises over the first predetermined voltage, the output 17 of the POR circuit changes from Vdd to 0 Volts. At this first switching point, the value of the supply voltage is called Von.

When the threshold value, which is a linear fraction of the supply voltage, drops below the second predetermined voltage, the output 17 of the POR circuit changes from 0 Volts to Vdd. At this second switching point, the value of the supply voltage is called Voff, where Voff is not equal to Von

Figure 2 illustrates the schematic of an embodiment of the POR circuit according to the invention.

The supply voltage, which is generated by the energy harvesting source, is applied to pin 15. Pin 16 is connected to ground and the output of the POR circuit, which generates the control pulse to the load, is connected to pin 17.

The POR circuit 10 consists of a nonlinear voltage reference generator 11, a linear voltage divider 13, a voltage comparator 12, and a voltage gain stages 14.

The voltage reference generator 11 consists of MOSFETs Q1 - Q4 which generate a reference voltage that is nonlinear dependent of the supply voltage 15. In this nonlinear voltage divider 11 the bottom three transistors Q2 - Q4 are diode connected. Since the resistance ratio changes when the supply voltage Vdd 15 is rising, the ratio of the output voltage to supply voltage Vdd 15 is also changing, which results in a nonlinear output voltage.

The linear voltage divider 13 consists of MOSFETs Q10 - Q12 which create a threshold voltage that is a fraction of the supply voltage 15. The transistors Q10 - Q12 of the linear voltage divider 13 always operate in cut-off region, assuring that all transistors Q10 - Q12 have the same resistance, which results in a linear output voltage and the output always has the same ratio of supply voltage Vdd 15.

The voltage comparator 12 consists of MOSFETs Q5 - Q9 which compares the reference voltage with the threshold voltage. The differential pair voltage comparator 12 detects the crossing point of the output signal of the nonlinear voltage reference generator 11 and the linear voltage divider 13.

The gain stages 14 consists of MOSFETs Q13 - Q18 which amplify the output power of the comparator to an POR output signal 17 suitable for the load attached to the POR circuit.

All of the NMOS and/or PMOS transistors Q1 - Q18 are using sub-threshold current to operate, resulting in sub nA current consumption of the POR circuit.

The output of the nonlinear voltage divider 11 is connected to one input of the differential pair 12 via switch 18, which realizes the different values of Von and Voff.

With switch 18 is in a first position, the output 17 of the POR circuit changes from Vdd to 0 Volts when the threshold value rises over the first predetermined reference voltage and the value of the supply voltage is equal to Von.

With switch 18 is in a second position, the output 17 of the POR circuit changes from 0 Volts to Vdd when the threshold value decays below the second predetermined reference voltage and the value of the supply voltage is equal to Voff.

Von and Voff can be changed by adapting the W/L ratio of the voltage reference generator. By using MOSFETs with other W/L ratio in the POR circuit the crossing point of the first and second predetermined reference voltage and the threshold voltage of the voltage divider and thereby Von and Voff change. Additionally, the intersection point of the reference voltage and the threshold voltage can be changed by adapting the output of the voltage divider. By either displacing the intermediate node and/or adding additional transistors, the ratio between the threshold voltage and the supply voltage of the voltage divider can be changed.

The schematically drawn switch 18 consists of two NMOS transistors. One MOSFET is connected to intermediate point 19 between MOSFETs Q1 and Q2 and is controlled by the output voltage 17 of the POR circuit. The other MOSFET is connected to intermediate point 20 of MOSFETs Q2 and Q3 and is controlled by the inverted output voltage of the POR circuit. When the supply voltage 15 is below Von and rising, the MOSFET connected to intermediate point 19 is on and the voltage of intermediate point 19 is compared with the threshold voltage. The MOSFET connected to intermediate point 20 is off. When supply voltage 15 reaches Von, output voltage 17 is toggles. The MOSFET connected to intermediate point 20 is switched on and the voltage of intermediate point 20 is compared with the threshold voltage, until the supply voltage 15 is reaches Voff. Because Voff is smaller than Von, this keeps on continuing creating a time window between turning the device on and off.

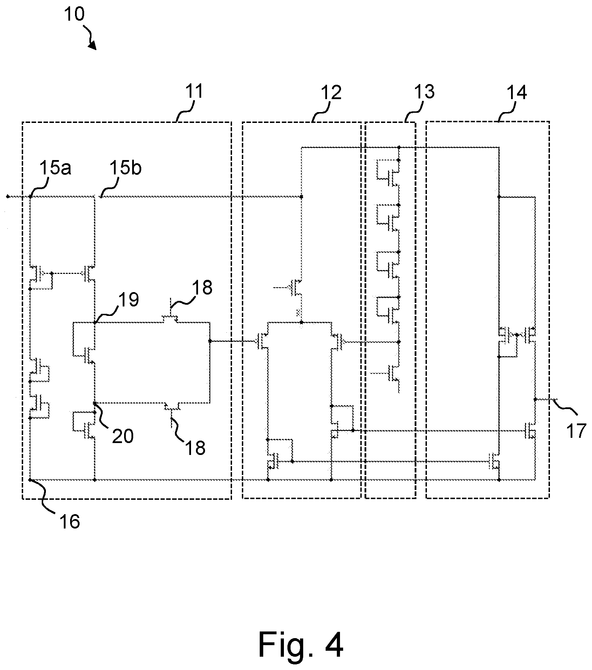

As an alternative to the embodiment of the POR circuit according to the invention as shown in the Figure 2, the voltage reference generator may also consists of two parallel branches of MOSFETs which generate a reference voltage or subthreshold current that is non-linear dependent of the supply voltage. This alternative embodiment is shown in Figure 4. Since the resistance ratio changes when the supply voltage Vdd is rising, the ratio of the output voltage to supply voltage Vdd is also changing, which results in a non-linear output voltage.

The first branch 15a of the alternative embodiment consists of three NMOS and/or PMOS transistors of which preferably one or more preferably all operate in cut-off region and which preferably comprise diode connected NMOS and/or PMOS transistors. The second branch 15b consists of three NMOS and/or PMOS transistors which preferably one or more preferably all operate in cut-off region and which preferably comprise diode connected NMOS and/or PMOS transistors. The gates of one of the transistors of both branches are connected to each other, thereby forming a two stage (non-linear) voltage reference generator or subthreshold current generator. With such an embodiment, the POR circuit and in particular the transistors of the voltage reference generator, operate under subthreshold current, but all the currents in each branch are mirrored from the left most branch. In this embodiment the area of the layout is optimized since all the current are the mirror of the same branch, also means for the same area available in the layout the biasing current can be larger, realizing a smaller spread across process corners and temperatures.

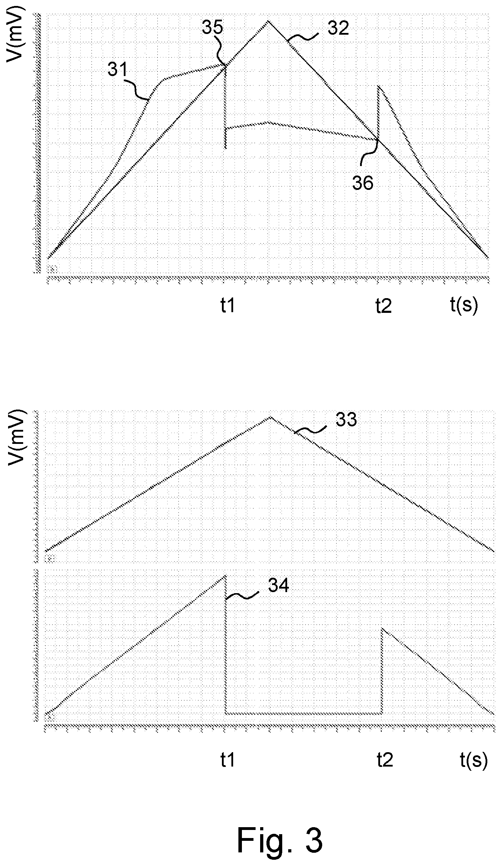

Figure 3 illustrates the first and second crossing point of the reference voltage signal with the threshold voltage signal according to the invention and the input and output voltage signal of the POR circuit according to the invention.

Graph 31 illustrates the output voltage of the nonlinear voltage divider 11 as a function of time and graph 32 illustrates the output voltage of the linear voltage divider 13 as a function of time. Graph 33 illustrates the supply voltage 15 of the POR circuit as a function of time and graph 34 illustrates the output voltage 17 of the POR circuit as a function of time. Notice that the graphs have a different scale.

Graph 31 and 32 show that the output of the voltage reference generator 11 and the voltage divider 13 is nonlinear and linear dependent of the supply voltage 33, 15 respectively.

The input voltage 15, 33 of the POR circuit, supplied by the cold starting energy harvester source, is rising until at time t = t1 the input voltage 15, 33 reaches the value Von and voltage comparator 12 detects that at point 35 the output voltage 32 of the voltage divider 13 output is equal to the output voltage 31 of the reference generator 11. At this moment the output voltage of the POR circuit 17, 34 stops tracking the supply voltage 15, 33 and drops to zero.

At a certain moment in time, the input voltage 15, 33 of the POR circuit is descending until at time t = t2 the input voltage 15, 33 reaches the value Voff and voltage comparator 12 again detects that at point 36 the output voltage 32 of the voltage divider 13 output is equal to the output voltage 31 of the reference generator 11. At this moment the output voltage of the POR circuit 17, 34 again starts tracking the supply voltage 15, 33.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

Furthermore, the invention may also be embodied with less components than provided in the embodiments described here, wherein one component carries out multiple functions. Just as well may the invention be embodied using more elements than depicted in the Figures, wherein functions carried out by one component in the embodiment provided are distributed over multiple components.

A person skilled in the art will readily appreciate that the stages of the converter comprise switches and that these switches can be embodied by several types of switches known in the art, such as but not limited to transistors, field-effect transistors, MOSFET, NMOS, etc.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single stage of the circuit or other unit may fulfil the functions of several items recited in the claims. The mere fact that certain measures are recited in mutually different dependent claims does not indicate that a combination of these measured cannot be used to advantage. Any reference signs in the claims should not be construed as limiting the scope thereof.

## Claims

1. A Power-On Reset, POR, circuit for generating a control signal to power-on a load, such as a wireless sensor node, for resetting at least one register of said load, when a supply voltage supplied to said load exceeds a predetermined value, said POR circuit comprising:
- a voltage reference generator arranged for generating a first reference voltage and a second reference voltage, wherein said first reference voltage and second reference voltage is nonlinear dependent of said supply voltage, wherein said second reference voltage differs from said first reference voltage;
- switching means arranged for selecting said first reference voltage or said second reference voltage;
- a voltage divider arranged for creating a threshold voltage, wherein said threshold voltage is a fraction of said supply voltage;
- a voltage comparator arranged for comparing said selected first or second reference voltage with said threshold voltage, wherein said voltage comparator generates a first output voltage when said threshold voltage is above said first reference voltage and a second output voltage when said threshold voltage is below said second reference voltage,
wherein said voltage divider comprises NMOS and/or PMOS transistors operating in cut-off region, and
wherein said voltage reference generator comprises of at least one NMOS or PMOS transistor operating in cut-off region in series connected to a plurality of diode connected NMOS and/or PMOS transistors.

2. A **POR** circuit according to any of the previous claims, wherein said first output voltage is a low voltage, for example 0 volts, and said second output voltage is a high voltage, for example equal to said supply voltage.

3. A POR circuit according to any of the previous claims, wherein said first output voltage is a low voltage, for example 0 volts, and said second output voltage is equal to said maximum supply voltage.

4. A POR circuit according to any of the previous claims, wherein said first output voltage is a high voltage, for example equal to said supply voltage, and said second output voltage is a low voltage, for example 0 volts.

5. A POR circuit according to any of the previous claims, wherein said switching means comprise of at least one switch.

6. A POR circuit according to any of the previous claims, wherein said switching means comprise of two switches.

7. A POR circuit according to any of the previous claims, wherein said switching means comprise of at least one NMOS and/or PMOS transistor.

8. A POR circuit according to any of the previous claims, wherein said first reference voltage and said second reference voltage is determined by selecting transistors having corresponding W/L characteristics.

9. A POR circuit according to any of the previous claims, wherein said POR circuit is further comprising at least one gain stage arranged for amplifying said output voltage of said voltage comparator.

10. A POR circuit according to any of the previous claims, wherein said at least one gain stage comprises NMOS and/or PMOS transistors.

11. A POR circuit according to any of the previous claims, wherein said POR circuit comprises NMOS and/or PMOS transistors.

12. A POR circuit according to any of the previous claims, wherein said voltage divider is a linear voltage divider.

13. APOR circuit according to any of the previous claims, wherein said voltage reference generator comprises of a single stage of transistors connected in series.

## Patentansprüche

1. Einschalt-Rücksetzschaltung, Power-On-Reset-, POR-Schaltung, zum Erzeugen eines Steuersignals zum Einschalten einer Last, wie eines drahtlosen Sensorknotens, zum Zurücksetzen mindestens eines Registers der Last, wenn eine Versorgungsspannung, die der Last zugeführt wird, einen vorbestimmten Wert überschreitet, wobei die POR-Schaltung Folgendes umfasst:
- einen Spannungsreferenzgenerator, der zum Erzeugen einer ersten Referenzspannung und einer zweiten Referenzspannung angeordnet ist, wobei die erste Referenzspannung und die zweite Referenzspannung nichtlinear von der Versorgungsspannung abhängen, wobei sich die zweite Referenzspannung von der ersten Referenzspannung unterscheidet;
- Schaltmittel, die zum Auswählen der ersten Referenzspannung oder der zweiten Referenzspannung angeordnet sind;
- einen Spannungsteiler, der zum Erzeugen einer Schwellenspannung angeordnet ist, wobei die Schwellenspannung ein Bruchteil der Versorgungsspannung ist;
- einen Spannungskomparator, der zum Vergleichen der ausgewählten ersten oder zweiten Referenzspannung mit der Schwellenspannung angeordnet ist, wobei der Spannungskomparator eine erste Ausgangsspannung, wenn die Schwellenspannung oberhalb der ersten Referenzspannung liegt, und eine zweite Ausgangsspannung erzeugt, wenn die Schwellenspannung unterhalb der zweiten Referenzspannung liegt,
wobei der Spannungsteiler NMOS- und/oder PMOS-Transistoren umfasst, die in der Cut-Off-Region arbeiten, und
wobei der Spannungsreferenzgenerator mindestens einen NMOS- oder PMOS-Transistor umfasst, der in der Cut-Off-Region arbeitet und mit einer Vielzahl von diodengeschalteten NMOS- und/oder PMOS-Transistoren in Reihe geschaltet ist.

2. POR-Schaltung nach einem der vorstehenden Ansprüche, wobei die erste Ausgangsspannung eine niedrige Spannung ist, zum Beispiel 0 Volt, und die zweite Ausgangsspannung eine hohe Spannung ist, zum Beispiel gleich der Versorgungsspannung.

3. POR-Schaltung nach einem der vorstehenden Ansprüche, wobei die erste Ausgangsspannung eine niedrige Spannung ist, zum Beispiel 0 Volt, und die zweite Ausgangsspannung gleich der maximalen Versorgungsspannung ist.

4. POR-Schaltung nach einem der vorstehenden Ansprüche, wobei die erste Ausgangsspannung eine hohe Spannung ist, zum Beispiel gleich der Versorgungsspannung, und die zweite Ausgangsspannung eine niedrige Spannung ist, zum Beispiel 0 Volt.

5. A POR-Schaltung nach einem der vorstehenden Ansprüche, wobei die Schaltmittel mindestens einen Schalter umfassen.

6. POR-Schaltung nach einem der vorstehenden Ansprüche, wobei die Schaltmittel zwei Schalter umfassen.

7. POR-Schaltung nach einem der vorstehenden Ansprüche, wobei die Schaltmittel mindestens einen NMOS- und/oder PMOS-Transistor umfassen.

8. POR-Schaltung nach einem der vorstehenden Ansprüche, wobei die erste Referenzspannung und die zweite Referenzspannung durch Auswählen von Transistoren mit entsprechenden W/L-Eigenschaften bestimmt werden.

9. POR-Schaltung nach einem der vorstehenden Ansprüche, wobei die POR-Schaltung ferner mindestens eine Verstärkungsstufe umfasst, die zum Verstärken der Ausgangsspannung des Spannungskomparators angeordnet ist.

10. POR-Schaltung nach einem der vorstehenden Ansprüche, wobei die mindestens eine Verstärkungsstufe NMOS- und/oder PMOS-Transistoren umfasst.

11. POR-Schaltung nach einem der vorstehenden Ansprüche, wobei die POR-Schaltung NMOS- und/oder PMOS-Transistoren umfasst.

12. POR-Schaltung nach einem der vorstehenden Ansprüche, wobei der Spannungsteiler ein linearer Spannungsteiler ist.

13. POR-Schaltung nach einem der vorstehenden Ansprüche, wobei der Spannungsreferenzgenerator eine einzelne Stufe von in Reihe geschalteten Transistoren umfasst.

## Revendications

1. Circuit de réinitialisation à la mise sous tension, circuit POR, destiné à générer un signal de commande pour mettre sous tension une charge, telle qu'un nœud de capteur sans fil, pour réinitialiser au moins un registre de ladite charge, quand une tension d'alimentation fournie à ladite charge dépasse une valeur prédéterminée, ledit circuit POR comprenant :
- un générateur de référence de tension conçu pour générer une première tension de référence et une deuxième tension de référence, lesdites première tension de référence et deuxième tension de référence dépendant de manière non linéaire de ladite tension d'alimentation, ladite deuxième tension de référence étant différente de ladite première tension de référence ;
- un moyen de commutation permettant de sélectionner ladite première tension de référence ou ladite deuxième tension de référence ;
- un diviseur de tension conçu pour créer une tension de seuil, ladite tension de seuil étant une fraction de ladite tension d'alimentation ;
- un comparateur de tensions conçu pour comparer ladite première tension de référence ou deuxième tension de référence sélectionnée avec ladite tension de seuil, ledit comparateur de tensions générant une première tension de sortie quand ladite tension de seuil est supérieure à ladite première tension de référence et une deuxième tension de sortie quand ladite tension de seuil est inférieure à ladite deuxième tension de référence,
dans lequel ledit diviseur de tension comprend des transistors NMOS et/ou PMOS fonctionnant en région de coupure, et
dans lequel ledit générateur de référence de tension comprend au moins un transistor NMOS ou PMOS fonctionnant en région de coupure en série connecté à une pluralité de transistors NMOS et/ou PMOS connectés par diode.

2. Circuit POR selon l'une quelconque des revendications précédentes, dans lequel la première tension de sortie est une tension basse, par exemple 0 volt, et ladite deuxième tension de sortie est une tension haute, par exemple égale à ladite tension d'alimentation.

3. Circuit POR selon l'une quelconque des revendications précédentes, dans lequel la première tension de sortie est une tension basse, par exemple 0 volt, et ladite deuxième tension de sortie est égale à ladite tension d'alimentation maximale.

4. Circuit POR selon l'une quelconque des revendications précédentes, dans lequel la première tension de sortie est une tension haute, par exemple égale à ladite tension d'alimentation, et ladite deuxième tension de sortie est une tension basse, par exemple 0 Volt.

5. Circuit POR selon l'une quelconque des revendications précédentes, dans lequel ledit moyen de commutation comprend au moins un commutateur.

6. Circuit POR selon l'une quelconque des revendications précédentes, dans lequel le moyen de commutation comprend deux commutateurs.

7. Circuit POR selon l'une quelconque des revendications précédentes, dans lequel ledit moyen de commutation comprend au moins un transistor NMOS et/ou PMOS.

8. Circuit POR selon l'une quelconque des revendications précédentes, dans lequel ladite première tension de référence et ladite deuxième tension de référence sont déterminées en sélectionnant des transistors ayant des caractéristiques W/L correspondantes.

9. Circuit POR selon l'une quelconque des revendications précédentes, ledit circuit POR comprenant en outre au moins un étage de gain conçu pour amplifier ladite tension de sortie dudit comparateur de tensions.

10. Circuit POR selon l'une quelconque des revendications précédentes, dans lequel ledit au moins un étage de gain comprend des transistors NMOS et/ou PMOS.

11. Circuit POR selon l'une quelconque des revendications précédentes, ledit circuit POR comprenant des transistors NMOS et/ou PMOS.

12. Circuit POR selon l'une quelconque des revendications précédentes, dans lequel ledit diviseur de tension est un diviseur de tension linéaire.

13. Circuit POR selon l'une quelconque des revendications précédentes, dans lequel ledit générateur de référence de tension comprend un unique étage de transistors connectés en série.
